# EUROPÄISCHE PATENTSCHRIFT

(11) **EP 0 653 840 B1**
(45) Veröffentlichungstag und Bekanntmachung des Hinweises auf die Patenterteilung: **09.02.2000**
(21) Anmeldenummer: 94117776.8
(22) Anmeldetag: 10.11.1994
(51) Int. Cl.: H03K 5/13, H03K 5/15

(54) **Schaltungsanordnung zur synchronen Takterzeugung wenigstens zweier Taktsignale**
Circuit to generate a synchronous clock with at least two clock signals
Circuit qui génère une horloge synchrone à au moins deux signaux d'horloge

(30) Priorität: 16.11.1993 DE 4339159
(43) Veröffentlichungstag der Anmeldung: 17.05.1995
(73) Patentinhaber: SIEMENS AKTIENGESELLSCHAFT, 80333 München (DE)
(72) Erfinder: Kirchhoff, Hans-Gerd, D-40885 Ratingen (DE); Püster, Harald, D-40699 Erkrath (DE)

(56) Entgegenhaltungen:
- US-A- 4 866 310
- US-A- 5 122 679
- US-A- 5 329 240

## Beschreibung

Die Erfindung betrifft eine Schaltungsanordnung zur Synchronisierung von mindestens zwei, aus einem einzelnen Eingangstaktsignal erzeugten Ausgangstaktsignalen.

Mikrocontroller mit aktuellen Entwurfstechniken zeichnen sich durch einen modularen Aufbau aus. Die einzelnen Komponenten werden weitestgehend voneinander separiert. Dies betrifft unter anderem auch den Takt, insbesondere die Takterzeugung, da z.B. differierende Ein- und Ausschaltbedingungen gelten, so daß nicht nur ein ein- oder mehrphasiges Taktsystem auf dem integrierten Schaltkreis existiert, sondern meistens mehrere, die blockweise aufgeteilt sind. Bei einer derartigen Vorgehensweise muß jedoch sichergestellt werden, daß die einzelnen Taktsysteme nicht ungewollt zueinander verschoben sind, was auch unter dem Begriff "clock skewing" bekannt ist.

Bisherige Taktgenerierungsschaltungen gehen von einem zentralen, einphasigen Takt aus, der mehr oder weniger direkt aus dem den Chip zugeführten Taktsignal abgeleitet wird. Dieser wird sodann verzweigt, die sich ergebenden Takte dann mit kombinatorischer Logik verknüpft und schließlich auf einen Ausgangstreiber gegeben. Die Minimierung des "clock skewings" erfolgt durch geeignete Dimensionierung der Ausgangstreiber, die an die aktuelle kapazitive Last angepaßt wird.

Im Dokument Patent Abstracts of Japan, Section E, Band 13 (1989), NR. 433 (E-824), JP-1-161912 ist eine Takterzeugungsschaltung gezeigt, bei der verschiedene Schaltungsblöcke jeweils einen Takteingangspuffer aufweisen, der Taktsignale für den jeweiligen Schaltungsblock bereitstellt. Die Takteingangspuffer werden von einem gemeinsamen Eingangstaktsignal gespeist. Sie weisen eine jeweils über ein Schieberegister einstellbare Zeitverzögerung auf. Der durch die Schieberegister einstellbare Verzögerungswert ist extern zuführbar.

Jedoch besitzt diese Art der Taktgenerierung mehrere Nachteile. So ist eine starke Abhängigkeit von der Dimensionierung der Ausgangstreiber festzustellen, die sich auch herstellungsseitig durch starke Prozeßschwankungen verschieben kann. Desweiteren ist auch keine Steuerung oder Kontrolle des "clock skewings" möglich.

In der US 4,866,310 ist ein Multiphasen-Taktsystem beschrieben. Das Multiphasen-Taktsystem weist jeweils Treiberstufen auf, in die jeweils eines dieser Taktsignale unterschiedlicher Phasenlage eingekoppelt wird. Die von den Treiberstufen ausgangsseitig bereitgestellten Ausgangstaktsignale werden über eine Logikschaltung verzweigt übertragen und die langsamsten Signale werden überkreuz in die jeweils anderen Treiberstufen eingekoppelt. Auf diese Weise können bezüglich ihrer Phasenlage nicht überlappende Ausgangstaktsignale bereitgestellt werden.

Aufgabe der vorliegenden Erfindung ist es, eine Schaltungsanordnung zur Synchronisierung von mindestens zwei, aus einem einzelnen Eingangstaktsignal erzeugten Ausgangstaktsignalen anzugeben, die zumindest einen der oben aufgezeigten Nachteile nicht aufweist.

Diese Aufgabe wird durch eine Schaltungsanordnung mit den Merkmalen des Patentanspruchs 1 gelöst. Eine Weiterbildung ist in dem einzigen Unteranspruch gekennzeichnet.

Die Erfindung wird nachfolgend anhand einer einzigen Figur, die ein Blockschaltbild der erfindungsgemäßen Anordnung zeigt, näher erläutert.

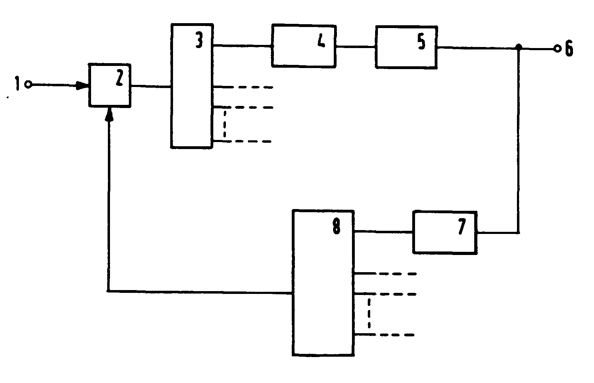

In Figur 1 ist mit 1 eine Eingangsklemme bezeichnet, an der ein z.B. von außen zuführbares Taktsignal, zugeführt werden kann. Mit 2 ist eine sogenannte Freigabestufe dargestellt, mittels derer die eigentliche Synchronisation der Taktsignale erfolgt. Die Freigabestufe 2 besitzt hierzu einen Steuereingang. Im einfachsten Fall kann die Freigabestufe 2 z.B. durch im Logikgatter, z.B. ein UND-Gatter, realisiert werden, dessen einem Eingang das Taktsignal und dessem zweiten Eingang das Steuersignal zugeführt wird.

Der Ausgang der Freigabestufe 2 ist mit einer Verzweigungsstufe 3 verbunden, die dazu dient, aus dem ihr zugeführten Taktsignale mehrere Taktsignale zu erzeugen. Der Übersichtlichkeit halber ist nachfolgend nur ein Schaltungszweig zur Erzeugung der Ausgangstaktsignale dargestellt. Dieser kann beispielsweise aus einer kombinatorischen Logikschaltung 4 und einer nachgeschalteten Treiberstufe 5 bestehen. Am Ausgang der Treiberstufe 5 ist über eine Ausgangsklemme 6 das eigentliche Ausgangstaktsignal abgreifbar. Von diesem Ausgangsanschluß 6 führt ein Abgriff zum Eingang eines Verstärkers 7, der als "sense amplifier" dient. Der Verstärker 7 weist beispielsweise einen niedrigen Arbeitspunkt auf, der nahe am negativen Versorgungspotential einer Versorgungsspannung liegt. Das Ausgangssignal dieses Verstärkers 7 wird einem ersten Eingang einer Logikanordnung 8 zugeführt. Die Logikanordnung 8 besitzt entsprechend der Anzahl von zu erzeugenden Taktsignalen eine Vielzahl von Eingängen. Das Ausgangssignal der Logikanordnung 8 wird zur Steuerung der Freigabestufe 2 herangezogen. Als Logikanordnung 8 kann im einfachsten Fall z.B. ein NAND-Gatter mit einer der Anzahl der Taktsignale entsprechenden Anzahl von Eingängen vorgesehen sein.

Die gesamte Anordnung gemäß Figur 1 bildet eine Synchronisationsschaltung, die durch einen einfachen Verriegelungsmechanismus ein "clock skewing" vermeidet. Hierzu werden die einzelnen erzeugten Takte hinter den Ausgangstreibern 5 abgegriffen, also an einer Stelle, an der durch Lastschwankungen das "clock skewing" auftreten kann. Dieser Abgriff wird dem "sense amplifier" 7 zugeführt, der durch seinen niedrigen Arbeitspunkt eine prozeßunabhängige Verzögerung des Umschaltzeitpunktes gegenüber der externen Beschaltung sicherstellt. Danach findet eine Verknüpfung der jeweiligen Ausgangssignale der "sense amplifier" 7 statt und eine Rückführung auf den über die Eingangsklemme 1 zugeführten Takt. Wird ein erwähntes NAND-Gatter verwendet, so wird dessen Ausgang erst dann auf logisch "0" geschaltet, wenn alle Eingänge logisch "0" sind. Erst dann wird der Takt über die Freigabe 2 freigegeben.

Auf diese Weise wird erreicht, daß zuerst alle Takte in einen deaktiven Low-Zustand schalten müssen, bevor ein Wechsel in den aktiven Zustand möglich wird. Die Flanke zum aktiven Zustand liegt durch die Synchronisierung bei allen Takten nahezu am selben Zeitpunkt. Selbstverständlich kann die Schaltung auch so ausgelegt werden, daß auf die fallende Flanke das Taktsignals synchronisiert wird.

## Patentansprüche

1. Schaltungsanordnung zur Synchronisierung von mindestens zwei, aus einem einzelnen Eingangstaktsignal (1) erzeugten Ausgangstaktsignalen (6), mit
- einer Freigabestufe (2), der das Eingangstaktsignal (1) zugeführt wird und die unter Steuerung eines Freigabesignals das Eingangstaktsignal (1) freigibt,
- einer Verzweigungsstufe (3), die aus dem freigegebenen Eingangstaktsignal (1) mindestens zwei Taktsignale erzeugt,
- jeweils einer für jedes Taktsignal vorgesehenen Logikschaltung (4) und/oder Treiberstufe (5), die der Verzweigungsstufe (3) nachgeschaltet sind und an deren Ausgängen die mindestens zwei Ausgangstaktsignale (6) abgreifbar sind,
- jeweils einer Verstärkerschaltung (7) für jedes Ausgangstaktsignal (6) zur Erfassung deren Taktflanken,
- einer Logikanordnung (8), zur logischen Verknüpfung der von den Verstärkerschaltungen (7) erzeugten Ausgangssignale und zur Bereitstellung des Freigabesignals bei dem Vorliegen des gleichen logischen Zustands aller Ausgangssignale.

2. Schaltungsanordnung nach Anspruch 1,
**dadurch gekennzeichnet**,
daß die Verstärkerschaltungen (7) als Sense-Amplifiers ausgebildet sind, die einen nahe am negativen Versorgungspotential einer Versorgungsspannung liegenden Arbeitspunkt aufweisen.

## Claims

1. Circuit arrangement for the synchronization of at least two output clock signals (6) generated from a single input clock signal (1), having
- an enable stage (2), to which the input clock signal (1) is fed and which enables the input clock signal (1) under the control of an enable signal,
- a branching stage (3), which generates at least two clock signals from the enabled input clock signal (1),
- in each case one logic circuit (4) and/or driver stage (5) provided for each clock signal, which are connected downstream of the branching stage (3) and at whose outputs the at least two output clock signals (6) can be tapped off,
- in each case one amplifier circuit (7) for each output clock signal (6) for detecting the clock-signal edges thereof,
- a logic arrangement (8), for logically combining the output signals generated by the amplifier circuits (7) and for providing the enable signal given the presence of the same logic state of all the output signals.

2. Circuit arrangement according to Claim 1,
characterized
in that the amplifier circuits (7) are designed as sense amplifiers having an operating point lying near the negative supply potential of a supply voltage.

## Revendications

1. Circuit de synchronisation d'au moins deux signaux d'horloge de sortie (6) produits à partir d'un seul signal d'horloge d'entrée (1), comportant :
- un étage de libération (2) qui reçoit le signal d'horloge d'entrée (1) et qui libère le signal d'horloge d'entrée (1) suivant la commande d'un signal de libération,
- un étage de ramification (3) qui produit au moins deux signaux d'horloge à partir du signal d'horloge d'entrée (1) libéré,
- respectivement un circuit logique (4) et/ou un étage d'attaque (5) qui sont prévus pour chaque signal d'horloge, qui sont branchés du côté aval de l'étage de ramification (3) et à la sortie desquels les deux ou plus signaux d'horloge de sortie (6) peuvent être prélevés,
- respectivement un circuit amplificateur (7) pour chaque signal d'horloge de sortie (6) en vue de la détection du flanc d'horloge de celui-ci,
- un circuit logique (8) pour la combinaison logique des signaux de sortie produits par les circuits amplificateurs (7) et pour la préparation du signal de libération lors de la présence du même état logique pour tous les signaux de sortie.

2. Circuit selon la revendication 1,
caractérisé par le fait que les circuits amplificateurs (7) sont conçus comme des "sense amplifier", c'est-à-dire qu'ils présentent un point de fonctionnement dynamique proche d'un potentiel d'alimentation négatif d'une tension d'alimentation.
